# EUROPÄISCHE PATENTANMELDUNG

(11) **EP 3 716 329 A1**
(43) Veröffentlichungstag der Anmeldung: **30.09.2020**
(21) Anmeldenummer: 19166194.1
(22) Anmeldetag: 29.03.2019
(51) Int. Cl.: H01L 25/07, H01L 25/18, H01L 23/48, H01L 23/00

(54) **LEISTUNGSMODUL MIT FLIP CHIP ANORDNUNG UND HERSTELLUNGSVERFAHREN FÜR EIN DERARTIGES LEISTUNGSMODUL**

(71) Anmelder: Heraeus Deutschland GmbH & Co. KG, 63450 Hanau (DE)
(72) Erfinder: Dietrich, Peter, 63322 Rödermark (DE); Hinrich, Andreas, 63579 Freigericht (DE)
(74) Vertreter: Kilchert, Jochen

(57) **Zusammenfassung**

Die vorliegende Erfindung betrifft ein elektronisches Leistungsmodul mit mindestens einer Halbbrücke 1, wobei die mindestens eine Halbbrücke einen ersten Transistor 2 als ersten Schalter und einen zweiten Transistor 3 als zweiten Schalter aufweist. Für einen kompakteren Aufbau, der geringere Schaltverluste aufweist, sind der erste Transistor 2 auf einem Substrat angeordnet und ein erster Anschluss des ersten Transistors 2 mit einem Substrat verbunden. Der zweite Transistor 3 weist einen mit dem zweiten Anschluss verbunden Substratadapter auf, und der zweite Transistor 3 ist neben dem ersten Transistor auf dem Substrat als Flip-Chip Anordnung angeordnet und der auf dem zweiten Anschluss angeordnete Substratadapter ist mit dem Substrat verbunden. Der erste und der zweite Transistor 2, 3 sind derart kontaktiert, dass eine Halbbrücke in dem elektronischen Leistungsmodul bereitgestellt ist. Zusätzlich bezieht sich die Erfindung auch auf ein Herstellungsverfahren für ein derartiges Leistungsmodul.

## Beschreibung

Die Erfindung betrifft ein Leistungsmodul mit Flip Chip Anordnung und ein Herstellungsverfahren für ein derartiges Leistungsmodul. Hierbei sind elektronische Leistungsmodule zu verstehen, die insbesondere in den technischen Bereichen wie z.B. Automotive, erneuerbare Energien, Traktion, Kraftwerke und Industrie ihren Einsatz finden.

Der Begriff "Flip Chip" beschreibt eine Anordnung oder ein Verfahren in der Aufbau- und Verbindungstechnik zur Kontaktierung von insbesondere ungehäusten Halbleiter-Chips (bzw. Dies) mittels Kontaktierhügeln aus Lot, insbesondere mittels Lotpunkten, -augen bzw. -körpern oder Solder Bumps. Hierbei werden auf dem Chip die Lotpunkte angebracht und mit der aktiven Kontaktierungsseite nach unten - zum Substrat oder Schaltungsträger hin - montiert. Die Flip Chip Technologie ist auch unter den Begriffen "Controlled Collapse Chip Connection" (C4) oder "Wende-Montage" bekannt.

Leistungsmodule weisen Stromrichter wie z.B. Wechselrichter bzw. Inverter, insbesondere in Form von steuerbaren Halbleiter-Halbbrücken auf. Stromrichter sind dazu ausgelegt, eine eingespeiste elektrische Stromart (Gleichstrom, Wechselstrom) in die jeweils andere umzuwandeln, oder charakteristische Parameter wie die Spannung und die Frequenz des eingespeisten Stroms zu ändern. Des Weiteren sind die Leistungsmodule bzw. deren Stromrichter in der Lage, hohe elektrische Ströme von z.B. mehreren hundert Ampere bereitzustellen. Voraussetzung hierfür sind unter anderem mehrere elektrische Leitungen und/oder elektrische Leiter mit großem Durchmesser bzw. Querschnitt, um große elektrische Ströme mit geringen (Wärme-)Verlusten leiten zu können.

Eine Halbbrücke wird im Wesentlichen durch einen oberen und einen unteren Arm, insbesondere in Form von zwei steuerbaren Transistoren, gebildet, die zwei unterschiedliche Spannungspole an ein gemeinsames Potential bzw. Leitung elektrisch verbinden können. Durch entsprechende Steuersignale an die Transistoren kann bekannterweise ein Wechselstrom erzeugt werden, der abwechselnd z.B. von der ersten Spannungsquelle zu der gemeinsamen Leitung und von der gemeinsamen Leitung zu der zweiten Spannungsquelle fließt.

Die Nachfrage nach höherer Leistung und längerer Betriebslebensdauer von Leistungselektronik-Modulen erhöht die Anforderungen an die elektrische Kontaktierung der Leistungshalbleiter und deren Eigenschaften.

Die hohen Ausgangsstromstärken erfordern die zuvor beschriebenen Leitungseigenschaften. Allerdings stößt der Stand der Technik in Form von Aluminium-Bonddrahtverbindungen an seine Grenzen. Aufgrund unterschiedlicher Längen der Bonddrahtverbindungen als Kontaktierung der Leistungselektroniktransistoren in einer Halbbrücke, insbesondere beim oberen und unteren Arm (bzw. Schalter) der Halbbrücke, ergeben sich unterschiedliche Induktivitäten. Diese Induktivitäten erzeugen ein Ungleichgewicht und führen zu Schaltverlusten bei der Ansteuerung der Halbbrücke, welche die maximale Ausgangsleistung begrenzt.

Des Weiteren führen die Schaltverluste zu einer Erwärmung der Halbleiter und in Folge dessen zu Halbleiterschäden und einer Reduzierung der Betriebslebensdauer des Leistungsmoduls. Um die Schäden zu vermeiden und die Alterung der Halbleiter zumindest zu verlangsamen, sind Kühleinrichtungen vorgesehen. Diese sind allerdings teuer und erhöhen das Gewicht und den Stromverbrauch eines Leistungsmoduls.

Als Aufgabe der vorliegenden Erfindung gilt es, die zuvor beschriebenen Probleme zu überwinden und Nachteile zu eliminieren, zumindest zu reduzieren. Insbesondere wird eine Lösung gesucht, mittels der die maximal mögliche Ausgangsleistung des Leistungsmoduls erhöht wird.

Zur Lösung der Aufgabe sind erfindungsgemäß ein Herstellungsverfahren nach Anspruch 1 und ein elektrisches Leistungsmodul nach Anspruch 8 vorgesehen.

Das erfindungsgemäße Verfahren zum Herstellen eines elektronischen Leistungsmoduls zeichnet sich durch folgende Schritte aus:
- Bereitstellen eines ersten Transistors als ersten Schalter und eines zweiten Transistors als zweiten Schalter, wobei beide Transistoren jeweils einen ersten und einen zweiten Anschluss (C, E) und einen Steueranschluss (G) aufweisen;
- Anordnen des ersten Transistors mit dem ersten Anschluss auf einem Substrat und Verbinden des ersten Anschlusses des ersten Transistors mit dem Substrat;
- Bereitstellen eines Substratadapters und Verbinden des Substratadapters mit dem zweiten Anschluss des zweiten Transistors;
- Anordnen des zweiten Transistors mit dem Substratadapter auf dem Substrat als Flip-Chip Anordnung neben dem ersten Transistor und Verbinden des Substratadapters mit dem Substrat; und
- Kontaktieren der Anschlüsse des ersten und des zweiten Transistors zu einer Halbbrücke für das elektronische Leistungsmodul.

Die Erfindung ermöglicht es, bekannte bzw. markübliche Leistungshalbleiterchips (vorzugsweise ohne Gehäuse) zu verwenden und als Flip Chip auszuführen, d.h. insbesondere diese zu wenden und entsprechend elektrisch zu kontaktieren. Insbesondere können die beiden Transistoren identisch sein, d.h. die gleiche Art, Form und Größe von Chip sein. Dabei kann die Oberseite des Chips den Emitteranschluss (E) und die Unterseite den Kollektoranschluss (C) bilden, oder umgekehrt. Zusätzlich ist ein Gate-Anschluss (G) als Steueranschluss beim Transistor ausgebildet, vorzugsweise auf der Ober- oder Unterseite oder an einer Ecke, am Rand oder an einer Seite des Chips und/oder auf der Emitter- oder Kollektorseite.

Mittels des gewendeten Transistors (Flip Chip) kann der obere Arm der Halbbrücke genauso wie der untere Arm strukturiert und aufgebaut werden. Die entsprechenden Leiterbahnen auf dem Substrat für den oberen und den unteren Arm der Halbbrücke können identisch geformt werden bzw. sein. Zusätzlich können beim Kontaktierungsschritt die Bonddrahtverbindungen innerhalb eines Arms und/oder zu den entsprechenden Ein- und Ausgängen der Halbbrücke gleich zu den jeweiligen Bonddrahtverbindungen des anderen Arms dimensioniert und/oder geformt werden. Dadurch wird im Vergleich zum Stand der Technik ein symmetrischer, kompakterer und kleinerer Aufbau der Halbbrücke und somit des Leistungsmoduls ermöglicht.

Die Induktivitäten (und somit die Schaltverluste) können durch kürzere elektrische Verbindungen, wie z.B. Bonddrähte und/oder Leiterbahnen, auf ein Minimum reduziert werden. Zusätzlich sind die Induktivitäten der elektrischen Verbindungen aufgrund der symmetrischen Struktur der Halbbrücke gleich groß und bilden kein Ungleichgewicht im oberen und unteren Arm der Halbbrücke. Die reduzierten und/oder symmetrisch ausgebildeten Induktivitäten erlauben höhere Schaltungsfrequenzen mit geringeren Schaltverlusten und somit eine höhere Ausgangsleistung des Moduls.

Der Substratadapter wird als Spacer (Abstandshalter) eingesetzt. Der umgedrehte Transistor (Flip Chip) kann, ohne dass die Passivierung das Substrat berührt, mittels des Adapters mit dem Substrat (DCB, Leadframe, usw.) thermisch und elektrisch kontaktiert werden. Dabei können normale, sinterbare Chips verwendet werden, deren Passivierung nicht extra angepasst werden muss. Der Substratadapter dient zusätzlich einem eventuellem Guard Ring des Transistors als Abstandshalter, um unter anderem einen Kurzschluss zwischen Guard Ring und Substrat vorzubeugen. Alternativ oder zusätzlich kann der Substratadapter den Gate-Kontakt des gewendeten Transistors zur besseren Kontaktierungsmöglichkeit verlegen, insbesondere außerhalb des Guard Rings und/oder von der Emitter- oder Kollektorseite.

Vorzugsweise sind der erste und der zweite Transistor jeweils ein IGBT, und/oder MOSFET und/oder ein anderer Schaltungstransistor, z.B. Bipolartransistor. Insbesondere IGBT sind leistungsstark und können im offenen Zustand Spannung mit mehreren Kilovolt unterbrechen und im geschlossenen Zustand Strom mit mehrere hundert Ampere durch deren n- bzw. p-Kanal weiterleiten.

Ebenso hat es sich als vorteilhaft herausgestellt, wenn jeweils eine Diode für den ersten und den zweiten Transistor bereitgestellt und mit den Transistoren als Freilaufdiode kontaktiert bzw. verbunden werden. Somit dienen diese Dioden zum Schutz des jeweiligen Transistors vor einer Überspannung beim Abschalten bzw. Unterbrechen des Transistors. Alternativ kann die Freilaufdiode bereits im Chip realisiert bzw. ausgebildet und mit dem Transistor parallel verbunden sein.

Gemäß einer bevorzugten Ausführungsform der Erfindung wird in einem zusätzlichen Schritt das Substrat bereitgestellt. Dabei weist das Substrat eine Leiterbahn auf, mit der sowohl der erste Transistor mit seinem ersten Anschluss und der zweite Transistor mittels des Substratadapters mit seinem zweiten Anschluss elektrisch verbunden sind. Diese eine Leiterbahn wird als Wechselspannungsanschluss bzw. -ausgang der Halbbrücke verwendet. Durch die Zusammenlegung des elektrischen Anschlusses wird die Anzahl an elektrischen Leitern beim Kontaktierungsschritt vorteilhafterweise reduziert.

In einer weiteren bevorzugten Ausführungsform weist das bereitgestellt Substrat eine erste Leiterbahn und eine zweite Leiterbahn auf, die voneinander getrennt und vorzugsweise gleich geformt sind. Insbesondere können die beiden Leiterbahnen als Inseln geformt sein. Hierbei sind der erste Transistor mit seinem ersten Anschluss auf der ersten Leiterbahn und der zweite Transistor mittels des Substratadapters mit seinem zweiten Anschluss auf der zweiten Leiterbahn elektrisch verbunden. In diesem Fall werden die Anschlüsse auf der Oberseite der beiden Transistoren jeweils mittels Bonddrähten mit einem Wechselspannungsanschluss der Halbbrücke verbunden, der insbesondere als dritte Leiterbahn auf dem Substrat ausgebildet ist. Die erste und zweite Leiterbahn werden mit einem Plus- und mit einem Minuspol einer Spannungsquelle verbunden, um die entsprechenden Transistoren mit Strom zu versorgen.

In einer weiteren vorteilhaften Ausführungsform des Verfahrens werden eine Vielzahl von Transistorpaaren aus ersten und zweiten Transistoren bereitgestellt. Diese Transistorpaare werden entsprechend auf dem Substrat angeordnet, elektrisch verbunden und zu einer Halbbrücke kontaktiert. Aufgrund der Vielzahl von Transistorpaaren, insbesondere der parallel geschalteten ersten bzw. zweiten Transistoren, kann die bereitgestellte Halbbrücke größere Ströme von z.B. bis 100A, 200A oder 300A erzeugen.

Ebenso können der Kontaktieren Schritt mittels einer oder mehrerer Bonddrähte, Clips und/oder Verbinder und die Verbinden Schritte mit dem Substrat mittels eines Lötschritts, Klebeschritts und/oder Sinterschritts erfolgen.

Vorzugsweise sind die Transistorpaare parallel zueinander auf dem Substrat, insbesondere nach einem symmetrischen Muster, angeordnet. Dabei können zuerst alle ersten Transistoren und danach alle zweiten Transistoren nebeneinander angeordnet sein. Alternativ können die ersten und zweiten Transistoren abwechselnd nebeneinander angeordnet sein. Ebenso können die Transistorpaare in einer, zwei oder mehreren Reihen angeordnet sein.

Des Weiteren besteht die Möglichkeit, dass ein Leistungsmodul ein oder mehrere Wechselspannungsausgänge aufweist und ein oder mehrere Transistorpaare mit jeweils einem Wechselspannungsausgang verbunden sind und so eine Halbbrücke bilden.

Die Erfindung offenbart des Weiteren ein elektronisches Leistungsmodul bzw. -vorrichtung mit mindestens einer Halbbrücke, wobei die mindestens eine Halbbrücke einen ersten Transistor als ersten Schalter und einen zweiten Transistor als zweiten Schalter aufweist. Der erste Transistor ist auf einem Substrat angeordnet und ein erster Anschluss des ersten Transistors ist mit einem Substrat verbunden. Der zweite Transistor weist einen zweiten Anschluss mit einem darauf angeordneten Substratadapter auf, wobei der zweite Transistor neben dem ersten Transistor auf dem Substrat als Flip-Chip Anordnung angeordnet ist und der auf dem zweiten Anschluss angeordnete Substratadapter mit dem Substrat verbunden ist. Dabei sind der erste und der zweite Transistor derart kontaktiert, dass ein Wechselrichter, insbesondere eine Halbbrücke, in dem elektronischen Leistungsmodul bereitgestellt ist.

Vorzugsweise sind der erste und der zweite Transistor jeweils ein IGBT oder MOSFET oder ein anderer Schaltungstransistor.

Des Weiteren können der erste und der zweite Transistor jeweils mit einer Freilaufdiode verschaltet sein, um Spannungsspitzen beim Abschalten auszugleichen und den Transistor zu schützen.

Der erste und zweite Anschluss sind der Kollektor und Emitter und der Steueranschluss ist der Gate- oder BASE-Anschluss des ersten bzw. zweiten Transistors.

Es hat sich als vorteilhaft herausgestellt, wenn der erste Anschluss mit dem Substrat mittels eines Anschluss-/Kontaktierungsdrahts und/oder Clips/Verbinder und der zweite Anschluss mit dem Substrat mittels des Substratadapters in Form eines Lots, Klebers und/oder Sinterung verbunden sind.

Vorzugsweise ist eine Vielzahl von den Halbbrücken im Leistungsmodul ausgebildet, wobei die Halbbrücken auf dem Substrat parallel zueinander angeordneten sind und jeweils einen eigenen Wechselspannungsausgang aufweisen.

Ebenso kann eine Halbbrücke auch eine Vielzahl von Transistorpaaren aus ersten und zweitem Transistor aufweisen, die parallel zueinander angeordnet und/oder verschaltet sind.

Das Leistungsmodul und dessen Herstellungsverfahren gemäß der vorliegenden Erfindung können des Weiteren wie folgt ausgezeichnet sein:
Mindestens eine oder alle Halbbrücken eines Leistungsmoduls werden jeweils durch mindestens einen ersten, an einem Pluspol verbundenen Transistor als ersten Teil bzw. Modul (der Halbbrücke) und durch mindestens einen zweiten, an einem Minuspol verbundenen Transistor als zweiten Teil gebildet. Hierbei ist der erste Teil der obere Abschnitt und der zweite Teil der untere Abschnitt des Halbbrücke. Die genannten Verbindungen zu den Spannungspolen können direkt oder indirekt, z.B. über weitere elektronische Bauteile, erfolgen.

Neben dem genannten mindestens einen Transistor und der Freilaufdiode können noch weitere elektronische Bauteile jeweils zu dem ersten und/oder zweiten Teil der Halbbrücke gehören. Der erste Teil und/oder der zweite Teil der Halbbrücke können einzeln oder gemeinsam, z.B. auf einer, zwei oder mehreren Leiterplatten bzw. Printed Circuit Board, PCB, ausgebildet sein. Das bedeutet, dass eine schnelle Anfertigung der Module möglich ist und ein Leistungsmodul je nach Bedarf mit einem oder mehreren Modulen angefertigt werden kann.

Zusätzlich ist das Leistungsmodul mit einer doppelseitigen Kühlung vorzugsweise ausgestattet. Die Kühlung kann in Form von einer Luft- oder Fluidkühlung durch einen Ventilator, Kühlrippen und/oder einen Fluidkreislauf erfolgen. Hierbei werden die Oberseite und/oder die Unterseite des Substrats gekühlt, wodurch das Leistungsmodul höhere Ströme liefern kann. Die dabei produzierte Abwärme wird durch die Kühlung abgeführt, wodurch die elektronischen Bauteile vor einer Überhitzung geschützt werden.

In einer alternativen Ausführungsform ist es auch möglich, anstelle einen Substratadapter bereitzustellen und mit dem zweiten Transistor zu verbinden, die Leiterbahnen des Substrats bzw. der Leiterplatte/n derart auszubilden, dass ein Steuersignal an den Steueranschluss an der Unterseite des Transistors geleitet werden kann und/oder die Unterseite des Transistors zumindest teilweise von der Oberfläche der Leiterbahn beabstandet ist. Das bedeutet allerdings, dass die Leiterbahnen für den ersten Transistor und den zweiten Transistor unterschiedlich sein können. Verglichen zur Ausführungsform mit dem Substratadapter wird die Fertigung des Leistungsmoduls, insbesondere der Halbbrücken, insgesamt aufwendiger - z.B. wegen einer genaueren Ausrichtung des Transistors, wobei jedoch der Substratadapter eingespart wird.

In einer weiteren vorteilhaften Ausführungsform werden MOSFET mit Bodydiode und/oder RC-IGBT verwendet. Dadurch muss der Schritt zum Bereitstellen und Verbinden/Kontaktieren einer Diode (anti)parallel zum Transistor nicht mehr ausgeführt werden.

Die nachfolgend beschriebenen Figuren beziehen sich auf bevorzugte Ausführungsbeispiele des erfindungsgemäßen Leistungsmoduls, wobei diese Figuren nicht als Einschränkung, sondern im Wesentlichen der Veranschaulichung der Erfindung dienen. Elemente aus unterschiedlichen Figuren, aber mit denselben Bezugszeichen sind identisch; daher ist die Beschreibung eines Elements aus einer Figur für gleichbezeichnete bzw. gleichnummerierte Elemente aus anderen Figuren auch gültig.

Es zeigen
- Fig. 1: ein Schaltdiagramm einer Halbbrücke mit zwei Transistoren und Freilaufdioden (entspricht zwei topologischen Schaltern);
- Fig. 2: eine Draufsicht auf eine Verschaltungsstruktur eines Leistungsmoduls mit einer Halbbrücke gemäß einem bevorzugten Ausführungsbeispiel;
- Fig. 3: eine Draufsicht auf eine Verschaltungsstruktur eines Leistungsmoduls mit einer Vielzahl von parallel geschalteten Transistoren gemäß einem weiteren bevorzugten Ausführungsbeispiel; und
- Fig. 4: eine Draufsicht auf eine Verschaltungsstruktur eines weiteren Leistungsmoduls mit einer Vielzahl von parallel geschalteten Transistoren gemäß einem weiteren bevorzugten Ausführungsbeispiel.

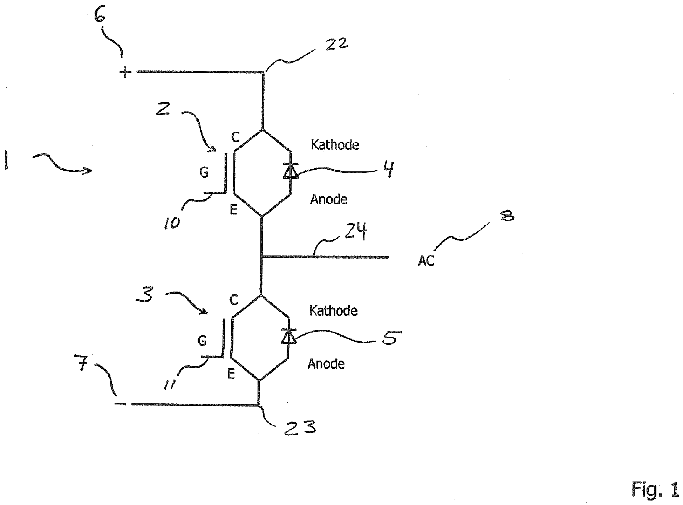

Fig. 1 zeigt ein Schaltdiagramm einer Halbbrücke 1 mit zwei seriell geschalteten Transistoren 2 und 3, die jeweils über einen Steueranschluss 10 bzw. 11 an deren Gate G angesteuert werden. Beide Transistoren 2, 3 haben jeweils eine antiparallel geschaltete Freilaufdiode 4, 5. Die Halbbrücke 1 weist somit einen oberen Arm mit dem ersten Transistor 2 und der ersten Diode 4 sowie einen unteren Arm mit dem zweiten Transistor 3 und der zweiten Diode 5 auf. Der Kollektor C des ersten Transistors 2 und die Kathode der (ersten) Freilaufdiode 4 sind über eine elektrische Leitung 22 mit einem Pluspol 6 einer Gleichstromquelle (nicht dargestellt) verbunden. Der Emitter E des zweiten Transistors 3 und die Anode der (zweiten) Freilaufdiode 5 sind über eine elektrische Leitung 23 mit einem Minuspol 7 der Gleichstromquelle verbunden. Der Emitter E des ersten Transistors 2 ist mit dem Kollektor C des zweiten Transistors 3 verbunden und an einer elektrischen Leitung 24 angeschlossen. Dabei werden der erste und der zweite Transistor 2, 3 über deren Steueranschluss 10, 11 bzw. Gate G mittels eines entsprechenden Steuersignals derart angesteuert, dass ein Wechselstrom AC erzeugt bzw. ein Wechselspannungspol 8 gebildet wird. Der Wechselstrom AC kann von der elektrischen Leitung 24 abgegriffen werden. An Stelle eines IGBTs kann auch ein MOSFET mit und ohne antiparalleler Diode verwendet werden.

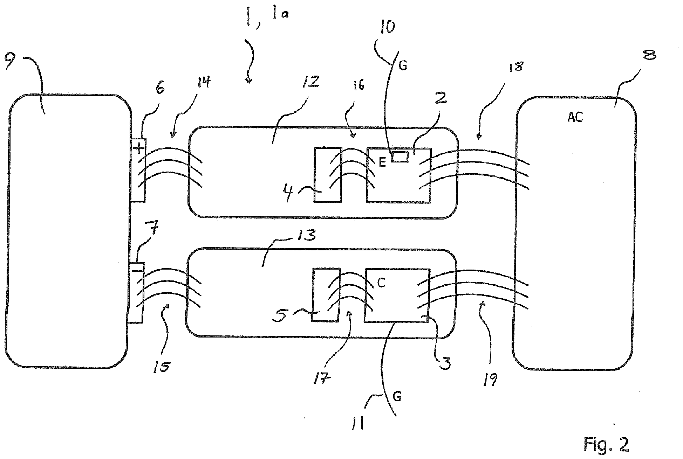

Fig. 2 zeigt eine Draufsicht auf eine Verschaltungsstruktur eines Leistungsmoduls mit einer Halbbrücke 1 gemäß einem bevorzugten Ausführungsbeispiel. Die Halbbrücke 1 ist gemäß dem Schaltdiagramm aus Fig. 1 aufgebaut und wird durch ein Transistorpaar 1a mit zwei seriell verschaltete Transistoren 2, 3 und jeweils einer parallelen Freilaufdiode 4, 5 gebildet. Ein Zwischenkondensator 9 als Gleichspannungsquelle weist einen Pluspol 6 und einen Minuspol 7 auf. Auf einer ersten Leiterbahn 12 (bzw. Leiterplatte oder Substrat) sind eine Freilaufdiode 4 und der erster Transistor 2 angeordnet und mit ihrer Unterseite mit der ersten Leiterbahn 12 elektrisch verbunden. Hierbei sind die Diode 4 mit ihrer Kathode und der Transistor 2 mit seiner Kollektorseite/kontaktfläche auf der Leiterbahn 12 befestigt. Das Gate des Transistors 2 ist mit einer Leiterverbindung 10 elektrisch verbunden und erlaubt darüber eine Ansteuerung des Transistors 2. Die Anode der Diode 4 ist mittels Bonddrahtverbindungen 16 (oder einer alternativen Verbindungstechnik) als Kontaktierung mit der Emitterseite des ersten Transistors 2 elektrisch verbunden. Auf einer zweiten Leiterbahn 13 sind eine Freilaufdiode 5 und der zweite Transistor 3 angeordnet und mit ihrer Unterseite mit der zweiten Leiterbahn 13 elektrisch verbunden. Hierbei ist die Diode 5 mit ihrer Anode und der Transistor 3 mit seiner Emitterseite/kontaktfläche mittels eines Substratadapters (nicht sichtbar) auf der Leiterbahn 13 befestigt. Die Kathode der Diode 5 ist mittels Bonddrahtverbindungen 17 oder einer alternativen Verbindungstechnik als Kontaktierung mit der Kollektorseite des zweiten Transistors 3 elektrisch verbunden. Zusätzlich ist zwischen dem zweiten Transistor 3 und der Leiterbahn 13 der Substratadapter (nicht sichtbar) angeordnet, der die Emitterseite des Transistors 3 mit der Leiterbahn 13 elektrisch verbindet und zusätzlich eine elektrische Kontaktierung 11 zum Gate (nicht sichtbar) des zweiten Transistors 3 ermöglicht. Der Substratadapter dient hierbei als Abstandhalter. Der Substratadapter hat auch den Vorteil, dass mit seiner Hilfe zwei identische Transistoren verwendet werden können, wobei einer der Transistoren (in diesem Fall der zweite Transistor 3) in Form einer Flip Chip Anordnung verwendet und angesteuert werden kann. Die Kontaktierungen 16 und 18 bzw. 17 und 19 können jeweils aus einem Teil bestehen oder verbunden sein, um von der entsprechenden Diode, zum entsprechenden Transistor und zum Wechselspannungspol 8 zu reichen. Die beiden Leiterbahnen 12 und 13 sind jeweils mittels einer Bonddrahtverbindung 14 bzw. 15 mit dem Plus- bzw. Minus-Pols 6, 7 des Kondensators 9 elektrisch verbunden. Zusätzlich wird die Oberseite der Transistoren 2, 3 jeweils mittels einer Bonddrahtverbindung 18 bzw. 19 mit einem Wechselspannungspol bzw. -ausgang 8 elektrisch verbunden, von der der durch die Halbbrücke 1 erzeugte Wechselstrom abgegriffen oder weitergeleitet werden kann. Bis auf den Substratadapter weisen der erste Teil und der zweite Teil der Halbbrücke 1, d.h. die Transistoren 2, 3, die Dioden 4, 5, die Leiterbahnen 12, 13 und die Bonddrahtverbindungen 14 bis 19, gleiche Komponenten und Abmessungen auf und sind in diesem Fall achsen- bzw. spiegelsymmetrisch zueinander angeordnet. Dabei werden die erste Leiterbahn 12 mit den darauf angeordneten oder verbundenen Komponenten als erster Teil bzw. Arm und die zweite Leiterbahn 13 mit den darauf angeordneten oder verbundenen Komponenten als zweiter Teil bzw. Arm der Halbbrücke 1 bezeichnet.

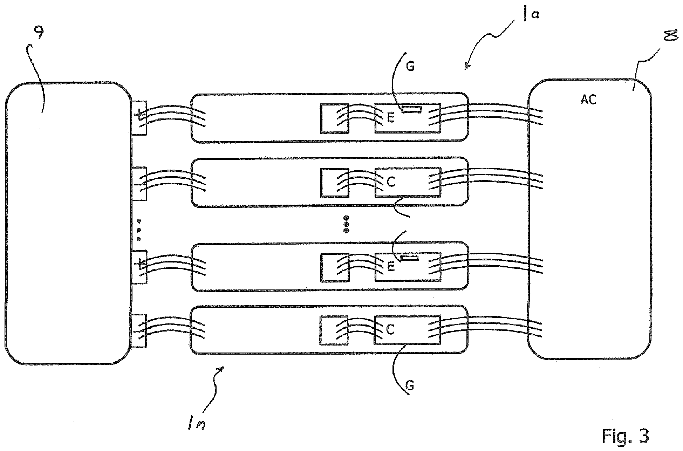

Fig. 3 zeigt eine Draufsicht auf eine Verschaltungsstruktur eines Leistungsmoduls mit einer Vielzahl von parallel geschalteten Transistoren gemäß einem weiteren bevorzugten Ausführungsbeispiel, die eine Halbbrücke bildet. Hierbei werden die Halbbrücke durch n Transistorpaare 1a bis 1n gebildet, die jeweils identisch zu der Halbbrücke aus Fig. 2 aufgebaut und strukturiert sind. Der Zwischenkondensator 9 weist n Paare von Minus- und Pluspolen auf, die der Anzahl n der Transistorpaare entspricht. Alle n Transistorpaare 1a bis 1n sind mit dem Wechselspannungsausgang 8 elektrisch verbunden. Da die Transistorpaare parallel zueinander verschaltet sind, kann eine größere Stromstärke des Wechselstroms erzeugt bzw. übertragen werden.

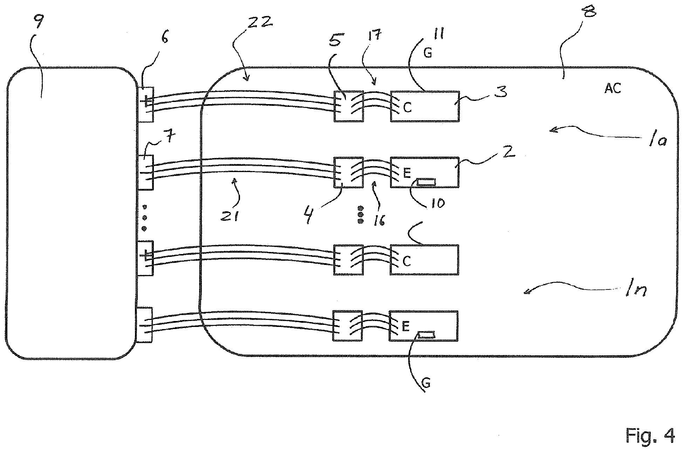

Fig. 4 zeigt eine Draufsicht auf eine Verschaltungsstruktur eines weiteren Leistungsmoduls mit einer Vielzahl von parallel geschalteten Transistoren gemäß einem weiteren bevorzugten Ausführungsbeispiel, die eine Halbbrücke bildet. Der Kondensator 9, die ersten und zweiten Transistoren 2 und 3 sowie die Freilaufdioden 4 und 5 sind bereits aus den Figuren 2 und 3 bekannt. Der Substratadapter des zweiten Transistors ist wiederum nicht sichtbar und zwischen Leiterbahn und Emitterseite angeordnet und mit diesen elektrisch verbunden. In diesem Fall sind allerdings alle ersten und zweiten Transistoren 2, 3 und deren Freilaufdioden 4, 5 auf einer einzigen Leiterbahn angeordnet und mit dieser elektrisch verbunden. Diese Leiterbahn bildet den Wechselspannungsausgang 8 der Halbbrücke, die n Transistorpaare 1a bis 1n mit jeweils einem ersten und einem zweiten Transistor 2, 3 aufweist. Diesmal ist die Anodenseite der ersten Freilaufdiode 4 und die Emitterseite des ersten Transistors 2 stets mittels der Kontaktierungen 16, 21 mit dem Minuspol 7 des Kondensators 9 elektrisch verbunden. Die Kathodenseite der zweiten Freilaufdiode 5 und die Kollektorseite des zweiten Transistors 3 sind stets mittels der Kontaktierungen 17, 22 mit dem Pluspol 6 des Kondensators 9 elektrisch verbunden. Der Vorteil dieses erfindungsgemäßen Ausführungsbeispiels liegt darin, dass es im Gegensatz zu Fig. 2 oder 3 die Kontaktierungen 18, 19 nicht gebraucht und somit zwei Kontaktierungen für jedes Transistorpaar gespart werden.

### Bezuqszeichenliste

- 1: Halbbrücke
- 1a: erstes Transistorpaar
- 1n: n-tes Transistorpaar
- 2: Erster Transistor
- 3: Zweiter Transistor
- 4: Freilaufdiode (des ersten Transistors)
- 5: Freilaufdiode (des zweiten Transistors)
- 6: Pluspol (einer Gleichspannungsquelle)
- 7: Minuspol (einer Gleichspannungsquelle)
- 8: Wechselspannungspol bzw. -ausgang
- 9: Gleichspannungsquelle / Kondensator
- 10: Gatekontaktierung/-anschluss (zum ersten Transistor)
- 11: Gatekontaktierung/-anschluss (zum zweiten Transistor)
- 12: Erstes Substrat bzw. Leiterbahn/fläche (für den ersten Transistor)
- 13: Zweites Substrat bzw. Leiterbahn/fläche (für den zweiten Transistor)
- 14: Kontaktierung von Pluspol - erstes Substrat
- 15: Kontaktierung von Minuspol - zweites Substrat
- 16: Kontaktierung von Freilaufdiode - erster Transistor
- 17: Kontaktierung von Freilaufdiode - zweiter Transistor
- 18: Kontaktierung von erstem Transistor - Wechselspannungspol
- 19: Kontaktierung von zweitem Transistor - Wechselspannungspol
- 20: Kontaktierung von Minuspol - Freilaufdiode
- 21: Kontaktierung von Pluspol - Freilaufdiode
- 22: elektrische Leitung/Verbindung von Pluspol - erster Transistor
- 23: elektrische Leitung/Verbindung von Minuspol - zweiter Transistor
- 24: elektrische Leitung/Verbindung zum Wechselspannungspol
- C: Kollektor
- G: Gate
- E: Emitter

## Patentansprüche

1. Verfahren zum Herstellen eines elektronischen Leistungsmoduls,
**gekennzeichnet durch**
folgende Schritte:
Bereitstellen eines ersten Transistors als ersten Schalter und eines zweiten Transistors als zweiten Schalter, wobei beide Transistoren jeweils einen ersten und einen zweiten Anschluss (C, E) und einen Steueranschluss (G) aufweisen;
Anordnen des ersten Transistors mit dem ersten Anschluss auf einem Substrat und Verbinden des ersten Anschlusses des ersten Transistors mit dem Substrat;
Bereitstellen eines Substratadapters und Verbinden des Substratadapters mit dem zweiten Anschluss des zweiten Transistors;
Anordnen des zweiten Transistors mit dem Substratadapter auf dem Substrat als Flip-Chip Anordnung neben dem ersten Transistor und Verbinden des Substratadapters mit dem Substrat; und
Kontaktieren der Anschlüsse des ersten und des zweiten Transistors zu einer Halbbrücke für das elektronische Leistungsmodul.

2. Verfahren nach Anspruch 1,
**dadurch gekennzeichnet, dass**
der erste und der zweite Transistor jeweils ein IGBT, und/oder MOSFET und/oder andere Schaltungstransistoren sind.

3. Verfahren nach Anspruch 1 oder 2,
**gekennzeichnet durch**
Bereitstellen jeweils einer Diode für den ersten und den zweiten Transistor; und Kontaktieren der Dioden mit den Transistoren als Freilaufdiode.

4. Verfahren nach einem der Ansprüche 1 bis 3,
**gekennzeichnet durch**
Bereitstellen des Substrats mit zwei getrennten Leiterbahnen, auf denen jeweils der erste und der zweite Transistor angeordnet und verbunden werden.

5. Verfahren nach einem der Ansprüche 1 bis 3,
**gekennzeichnet durch**
Bereitstellen des Substrats mit einer Leiterbahn, auf dem der erste und der zweite Transistor angeordnet und verbunden werden.

6. Verfahren nach einem der Ansprüche 1 bis 5,
**dadurch gekennzeichnet, dass**
der Kontaktieren Schritt mittels einer oder mehrerer Bonddrähte, Clips und/oder Verbinder und die Verbinden Schritte mit dem Substrat mittels eines Lötschritts, Klebeschritts und/oder Sinterschritts erfolgt.

7. Verfahren nach einem der Ansprüche 1 bis 6,
**gekennzeichnet durch**
Bereitstellen einer Vielzahl von zueinander parallel geschalteten Transistorpaaren von ersten und zweiten Transistoren, die topologisch zu einer Halbbrücke verschaltet werden;
Anordnen der Transistoren auf dem Substrat nach einem vorbestimmten Muster.

8. Elektronisches Leistungsmodul mit mindestens einer Halbbrücke, wobei die mindestens eine Halbbrücke einen ersten Transistor als ersten Schalter und einen zweiten Transistor als zweiten Schalter aufweist, wobei beide Transistoren jeweils einen ersten und einen zweiten Anschluss (C, E) und einen Steueranschluss (G) aufweisen **dadurch gekennzeichnet, dass**
der erste Transistor (2) auf einem Substrat angeordnet ist und der erste Anschluss des ersten Transistors (2) mit einem Substrat verbunden ist; und
der zweite Transistor (3) einen mit dem zweiten Anschluss verbunden Substratadapter aufweist, und der zweite Transistor (3) neben dem ersten Transistor auf dem Substrat als Flip-Chip Anordnung angeordnet ist und der auf dem zweiten Anschluss angeordnete Substratadapter mit dem Substrat verbunden ist, und
wobei der erste und der zweite Transistor derart kontaktiert sind, dass eine Halbbrücke (1) in dem elektronischen Leistungsmodul bereitgestellt ist.

9. Elektronisches Leistungsmodul nach Anspruch 8,
**dadurch gekennzeichnet, dass**
der erste und der zweite Transistor jeweils ein IGBT und/oder MOSFET und/oder anderer Schaltungstransistoren sind.

10. Elektronisches Leistungsmodul nach Anspruch 8 oder 9,
**dadurch gekennzeichnet, dass**
der erste und der zweite Transistor jeweils mit einer Freilaufdiode (4; 5) verschaltet sind.

11. Elektronisches Leistungsmodul nach einem der Ansprüche 8 bis 10,
**dadurch gekennzeichnet, dass**
der erste Transistor (2) auf einer ersten Leiterbahn (12) und der zweite Transistor (3) auf einer zweiten Leiterbahn (13) des Substrats angeordnet und verbunden sind.

12. Elektronisches Leistungsmodul nach einem der Ansprüche 8 bis 10,
**dadurch gekennzeichnet, dass**
der erste Transistor und der zweite Transistor auf einer Leiterbahn (8) des Substrats angeordnet und verbunden sind.

13. Elektronisches Leistungsmodul nach einem der Ansprüche 8 bis 11,
**dadurch gekennzeichnet, dass**
die Transistoren (2; 3) mit einer oder mehreren Bonddrähten (16; 17; 18; 19) und/oder Clips/Verbindern kontaktiert sind und der erste Anschluss und der Substratadapter mit dem Substrat mittels Lots, Kleber und/oder Sinterung verbunden sind.

14. Elektronisches Leistungsmodul nach einem der Ansprüche 8 bis 12,
**gekennzeichnet durch**
eine Vielzahl von zueinander parallel geschalteten Transistorpaaren (1a; 1n) von ersten und zweiten Transistoren, die nach einem vorbestimmten Muster auf dem Substrat angeordnet sind.
